# EUROPEAN PATENT APPLICATION

(11) **EP 4 039 644 A1**
(43) Date of publication of application: **10.08.2022**
(21) Application number: 20872147.2
(22) Date of filing: 24.09.2020
(51) Int. Cl.: C01B 33/02, C01B 33/035

(54) **APPARATUS AND METHOD FOR PRODUCING POLYCRYSTALLINE SILICON, AND POLYCRYSTALLINE SILICON**

(30) Priority: 02.10.2019 JP 2019182377
(71) Applicant: Tokuyama Corporation, Shunan-shi, Yamaguchi 745-8648 (JP)
(72) Inventor: ISHIKAWA, Koichi, Shunan-shi, Yamaguchi 745-8648 (JP)
(74) Representative: Bittner, Thomas L.
(86) International application number: PCT/JP2020/036104
(87) International publication number: WO 2021/065685

(57) **Abstract**

The present invention decreases the impurity concentration of polycrystalline silicon to be produced. An apparatus (1) for producing polycrystalline silicon (S1) includes: a reactor (10) that contains a raw material gas (G1) for silicon deposition; a feed pipe (20) that forms a feed channel for feeding the raw material gas (G1) into the reactor (10), the feed pipe (20) including an inflow port (111) which is formed in the reactor (10) and through which the raw material gas (G1) flows in; and a filter (30) for removing impurities which have mixed in the raw material gas (G1), the filter (30) being provided in the feed channel.

## Description

The present invention relates to an apparatus and a method for producing polycrystalline silicon, and the polycrystalline silicon.

### Background

Conventionally, for example, the Siemens method has been known as one of methods for producing polycrystalline silicon which is to be used as a raw material for semiconductor wafers or photovoltaic wafers. In the Siemens method, first, a silicon core wire placed inside a bell-jar type reactor is heated to silicon deposition temperature by passing current through the silicon core wire. In this state, for example, trichlorosilane (SiHCl₃) and hydrogen (H₂) are fed into the reactor, so that polycrystalline silicon is deposited on the silicon core wire. As a result, polycrystalline silicon in the form of a rod is obtained.

JP 2018-530511 discloses a reactor which includes a feed gas system and an offgas system. One or each of the feed gas system and the offgas system has an opening or meshes, and includes at least one protective element. The protective element is provided so as to prevent polycrystalline silicon shards from falling into the opening for feed gas and the opening for offgas and blocking gas conduits or gas distributors.

### Summary

### Technical Problem

However, adhesion of impurities originating from a material used for pipes and/or the like may occur in a feed channel for feeding a raw material gas into the reactor. When the raw material gas is fed to the reactor, the impurities may scatter in the reactor and adhere to polycrystalline silicon being deposited. This may lead to an increase in impurity concentration of polycrystalline silicon to be produced.

Since the size of the impurities is very small, it is difficult to prevent, with use of the protective element disclosed in Patent Literature 1, contamination caused by the impurities. Therefore, the conventional technique disclosed in Patent Literature 1 has a problem in that the impurity concentration of polycrystalline silicon to be produced increases. The purpose of an aspect of the present invention is to decrease the impurity concentration of polycrystalline silicon to be produced.

### Solution to Problem

In order to solve the above problem, an apparatus in accordance with an aspect of the present invention for producing polycrystalline silicon includes: a reactor that contains a raw material gas for silicon deposition; a pipe that forms a feed channel for feeding the raw material gas into the reactor, the feed channel including an inflow port which is formed in the reactor and through which the raw material gas flows in; and a filter for removing an impurity which has mixed in the raw material gas, the filter being provided in the feed channel.

A method in accordance with an aspect of the present invention for producing polycrystalline silicon includes the steps of: removing an impurity which has mixed in a raw material gas for silicon deposition, by a filter provided in a feed channel for feeding the raw material gas into a reactor which contains the raw material gas; and depositing polycrystalline silicon by feeding, into the reactor, the raw material gas from which the impurity has been removed in the step of removing the impurity.

### Advantageous Effects of Invention

An aspect of the present invention makes it possible to reduce the impurity concentration of polycrystalline silicon to be produced.

### Brief Description of Drawings

- Fig. 1: is a view schematically illustrating an apparatus in accordance with Embodiment 1 of the present invention for producing polycrystalline silicon.
- Fig. 2: is a cross-sectional view illustrating a configuration of a filter which is provided in the apparatus illustrated in Fig. 1 for producing the polycrystalline silicon.
- Fig. 3: is a view schematically illustrating an example of a configuration of a filter which is provided in an apparatus in accordance with Embodiment 2 of the present invention for producing polycrystalline silicon.
- Fig. 4: is a graph showing a filtration accuracy of the filter illustrated in Fig. 3.
- Fig. 5: is a view illustrating an example of a configuration of a filter which is provided in an apparatus in accordance with Embodiment 3 of the present invention for producing polycrystalline silicon.
- Fig. 6: is a view illustrating an example of a configuration of a filter which is provided in an apparatus in accordance with Embodiment 4 of the present invention for producing polycrystalline silicon.

### Description of Embodiments

### Embodiment 1

### <Configuration of apparatus 1 for producing polycrystalline silicon S1>

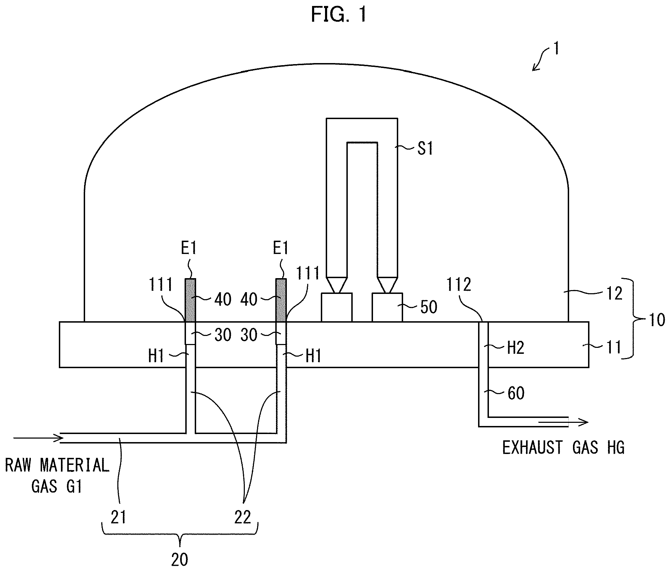

Fig. 1 is a view schematically illustrating an apparatus 1 in accordance with Embodiment 1 of the present invention for producing polycrystalline silicon S1. As illustrated in Fig. 1, the production apparatus 1 for producing the polycrystalline silicon S1 includes a reactor 10, a feed pipe 20 (pipes), filters 30, feed nozzles 40, electrodes 50, and an exhaust pipe 60. Note that the above production apparatus 1 need not necessarily include the feed nozzles 40.

The reactor 10 is composed of a base part 11 where the polycrystalline silicon S1 is placed, and a bell-jar type lid part 12 which is detachably connected to the base part 11. The reactor 10 contains a raw material gas G1 for silicone deposition while the lid part 12 is connected to the base part 11. The raw material gas G1 is a mixed gas of a chlorosilane and hydrogen.

The base part 11 is provided with inflow ports 111 and an exhaust port 112. The inflow ports 111 are for allowing the raw material gas G1 to flow into the reactor 10, and the exhaust port 112 is for discharging exhaust gas HG in the reactor 10 after reaction from inside the reactor 10. From the inflow ports 111, respective through holes H1 extend so as to penetrate through the base part 11. From the exhaust port 112, a through hole H2 extends so as to penetrate through the base part 11. In Fig. 1, two inflow ports 111 are formed on the base part 11 and one exhaust port 112 is formed on the base part 11. However, the number of inflow ports 111 to be formed and the number of exhaust ports 112 to be formed on the base part 11 are not particularly limited.

The feed pipe 20 is composed of a first pipe 21, and second pipes 22. The first pipe 21 has one end connected to a supply unit (not illustrated) for supplying the raw material gas G1, and the other end connected to the second pipes 22. The raw material gas G1 can be fed evenly to the inflow ports 111. In Fig. 1, the number of the second pipes 22 is two, and is equal to the number of the inflow ports 111. Accordingly, the number of the second pipes 22 can be changed as appropriate in accordance with the number of the inflow ports 111.

The second pipes 22 are each connected to the first pipe 21 and the base part 11. The second pipes 22 each extend between a connection of the first pipe 21 and the second pipe 22 and an end of the through hole H1 on a side opposite to the inflow port 111. Note that the second pipes 22 each may extend between the connection of the first duct 21 and the second duct 22 and the inflow port 111.

The feed pipe 20 is made of, for example, stainless steel. The stainless steel is an alloy which contains, as a constituent element, for example, at least one of elements such as Fe, Ni, Cr, Mn, Cu, Ti, Mo and Nb. In a case where the feed pipe 20 is corroded by the raw material gas G1, an impurity originating from the constituent element of the stainless steel mixes in the raw material gas G1. The impurity includes oxides and chlorides of the constituent element of the stainless steel.

Since the feed pipe 20 is made of stainless steel, it is possible to prevent, for example, at least one of Fe, Ni, Cr, Mn, Cu, Ti, Mo and Nb, which are heavy metals, from entering the reactor 10 due to a constituent element(s) of stainless steel.

A feed channel for feeding the raw material gas G1 into the reactor 10 is formed by the feed pipe 20, the inflow ports 111, and the feed nozzles 40. In other words, the feed channel includes the inflow ports 111, and the feed pipe 20 forms the feed channel. The feed channel also includes inflow ports E1 of the feed nozzles 40, that is, the tips of the feed nozzles 40.

The feed nozzles 40 are respective nozzles which protrude from the inflow ports 111 into the reactor 10. The feed nozzles 40 are provided on the base part 11 so as to cause the raw material gas G1, which flows in through the inflow ports 111, to reach an upper area in the reactor 10 and to cause the polycrystalline silicon S1 to evenly grow. Further, the feed nozzles 40 are for preventing the raw material gas G1 from directly coming to the electrodes 50 or the vicinity of the electrodes 50. The feed nozzles 40 make it possible to prevent the polycrystalline silicon S1 from easily broken.

The feed nozzles 40 are preferably made of a material that is highly corrosion-resistant to the raw material gas G1. The feed nozzles 40 are made of, for example, carbon. The feed nozzles 40 each have the shape of a nozzle, but may have a shape other than the shape of a nozzle. The feed nozzles 40 each may be, for example, an orifice plate which is provided at the inflow port 111.

The electrodes 50 are each a member for supplying electric power to a silicon core wire (not illustrated) which is electrically connected to the electrodes 50, and are each also a member for heating the silicon core wire by passing current through the silicon core wire. At least one pair of the electrodes 50 is provided on the base part 11. The number of the electrodes 50 is determined in accordance with the number of silicon core wires which are to be provided inside the reactor 10.

The exhaust pipe 60 is a pipe for discharging, to the outside of the reactor 10, the exhaust gas HG which has been generated in the step of depositing silicon (which will be described later). The exhaust pipe 60 extends between the outside of the reactor 10 and an end of the through hole H2 on a side opposite to the exhaust port 112. The exhaust pipe 60 may extend between the outside of the reactor 10 and the exhaust port 112.

### <Configuration of filters 30>

The filters 30 are each a member which is provided in the feed channel and which is for removing impurities which have mixed in the raw material gas G1. In other words, the filter 30 is provided in/at any one of the feed pipe 20, the inflow ports 111, the feed nozzles 40 and the inflow ports E1. In order to minimize the amount of the impurities that enter the reactor 10, the filters 30 are preferably provided in the feed channel in the vicinity of the reactor 10 or inside the reactor 10. For example, it is preferable that the filters 30 be provided at the inflow ports 111 in the feed channel.

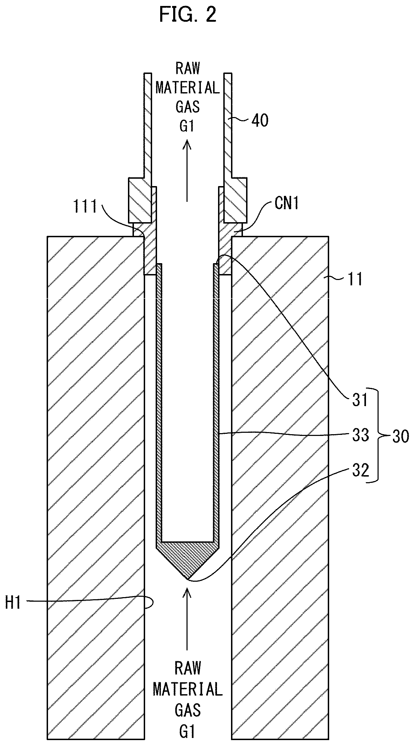

Fig. 2 is a cross-sectional view illustrating a configuration of the filter 30 which is provided in the apparatus 1 illustrated in Fig. 1 for producing the polycrystalline silicon S1. As illustrated in Fig. 2, the filter 30 has a cylindrical shape and has a first end 31, a second end 32, and a filter surface 33. The filter 30 is shaped such that the first end 31 is open while the second end 32 on a side opposite to the first end 31 is closed and that the filter surface 33 extends between the first end 31 and the second end 32.

The filter 30 is preferably made of a material that is highly corrosion-resistant to the raw material gas G1. The filter 30 can be preferably made of, for example, stainless steel which contains not less than 10% of Ni, a corrosion-resistant material (HASTELLOY, Inconel 600, Incoloy 800, Incoloy 800H, or the like), or a ceramic (alumina, titania, zirconia, quartz, silicon carbide, silicon nitride, aluminum nitride, or the like). In consideration of economic efficiency, the filter 30 is preferably made of stainless steel which contains not less than 10% of Ni, and more desirably made of SUS316L.

The first end 31 is provided on a downstream side of the feed channel, and the second end 32 is provided on an upstream side of the feed channel. The filter 30 has a structure in which the first end 31 is provided on a side opposite to the second end 32. The first end 31 of the filter 30 is fixed to a connecting member CN1 which is attached to the inflow port 111. To one end of the connecting member CN1, the filter 30 is fixed. To the other end of the connecting member CN1, the feed nozzle 40 is attached. It is possible to easily carry out cleaning of the filter 30 which is fixed to the connecting member CN1, by detaching the connecting member CN1 from the inflow port 111.

The outer periphery of the first end 31 is fixed to an inner wall of the feed channel so that the first end 31 and the second end 32 are aligned along the inner wall of the feed channel. In other words, the outer periphery of the first end 31 is fixed to an inner wall of at least one of the feed pipe 20, the through hole H1 of the base part 11, and the feed nozzle 40.

According to the above configuration, the surface area of the filter 30 can be increased. This makes it possible to reduce pressure loss which occurs in the raw material gas G1 due to installation of the filter 30. Further, it is possible to stably feed the raw material gas G1 without blockage of the filter 30, until deposition of the polycrystalline silicon S1 completes. Therefore, it is possible to efficiently produce the polycrystalline silicon S1.

Note that the filter surface 33 may be made of, for example, a mesh, or a sintered body of fine powder of a metal, ceramic, or the like. Furthermore, the filter surface 33 may be made of a structure in which a mesh and a sintered body are put on top of each other. In this case, preferably, the mesh is provided on an outer side, while the sintered body is provided on an inner side.

According to the configuration of the production apparatus 1, the impurities which have mixed in the raw material gas G1 for silicon deposition can be removed by the filter 30 as described above. Therefore, the polycrystalline silicon S1 can be produced by feeding, into the reactor 10, the raw material gas G1 from which the impurities have been removed. Therefore, it is possible to reduce the impurity concentration of the polycrystalline silicon S1 to be produced.

### <Method for producing polycrystalline silicon S1>

Next, the following description will discuss an example of a method for producing the polycrystalline silicon S1. First, impurities which have mixed in the raw material gas G1 is removed by the filter 30 (the step of removing impurities). It is preferable that the step of removing impurities be performed immediately before the raw material gas G1 is fed into the reactor 10. As a result, the amount of impurities which enter the reactor 10 can be minimized.

After the step of removing impurities, the raw material gas G1 from which the impurities have been removed in the step of removing impurities is fed into the reactor 10, so that the polycrystalline silicon S1 is deposited (the step of depositing silicon). Further, in the method for producing the polycrystalline silicon S1, it is preferable that the raw material gas G1 be a mixed gas of a chlorosilane and hydrogen.

This makes it possible to prevent rust and chlorides from entering the reactor 10, even in a case where (i) a chlorosilane having chlorine in a molecule and also having corrosivity is contained in the raw material gas G1, (ii) rust and chlorides are generated on a surface of the feed pipe 20 due to corrosion of a material of the feed pipe 20, and (iii) part of the rust and chlorides mixes in the raw material gas G1.

Examples of the chlorosilane include tetrachlorosilane, trichlorosilane, dichlorosilane and monochlorosilane. In general, trichlorosilane is suitably used as the chlorosilane. Note that the polycrystalline silicon S1 which is produced by the above-described method for producing the polycrystalline silicon S1 is also included in the technical scope of the present invention.

### Embodiment 2

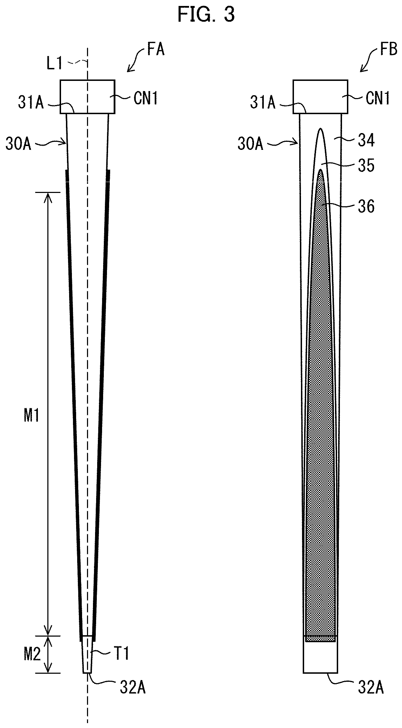

The following will discuss Embodiment 2 of the present invention. Note that, for convenience of explanation, a member having the same function as the member described in Embodiment 1 will be given the same reference sign, and a description thereof will not be repeated. Fig. 3 is a view schematically illustrating an example of a configuration of a filter 30A which is provided in an apparatus in accordance with Embodiment 2 of the present invention for producing polycrystalline silicon S1. In Fig. 3, a diagram indicated by "FA" is a front view of the filter 30A, and a diagram indicated by "FB" is a side view of the filter 30A.

Such a production apparatus in accordance with Embodiment 2 differs from the production apparatus 1 in accordance with Embodiment 1 in that the filter 30 is replaced by the filter 30A. As shown in Fig. 3, a portion of the filter 30A is tapered from a first end 31A which is connected to a connecting member CN1 toward a second end 32A which is on an opposite side of the first end 31A. In other words, the portion of the filter 30A is tapered from an inflow port 111 toward an upstream side of the feed channel.

Note that the filter 30A may have at least a portion that is tapered from the inflow port 111 toward the upstream side of the feed channel. The production apparatus in accordance with Embodiment 2 may be provided with a filter which has at least a portion that is tapered from the upstream side of the feed channel toward the inflow port 111 in a reverse manner, in place of the filter 30A.

According to the configuration of the filter 30A, even in a case where a raw material gas G1 collides with the filter 30A, it is possible to reduce obstruction caused by the filter 30A to flow of the raw material gas G1. This makes it possible to reduce pressure loss which occurs in the raw material gas G1 due to installation of the filter 30A. On the other hand, the following examines a case of using the filter which has at least a portion that is tapered from the upstream side of the feed channel toward the inflow port 111. Even in this case, since a space through which the raw material gas G1 passes becomes wider from the upstream side of the feed channel toward the inflow port 111, it is possible to cause the raw material gas G1 to smoothly pass through the feed channel. Therefore, the pressure loss of the raw material gas G1 due to the installation of the filter can be reduced.

As illustrated in the diagram indicated by "FB" in Fig. 3, a portion of the surface 34 of the filter 30A is cut out. Accordingly, the filter 30A has a cutout surface 35 thus formed. To the cutout surface 35, a plate-shaped filter 36 is attached. Accordingly, the plate-shaped filter 36 forms a filter surface. Note that the cutout surface 35 and the plate-shaped filter 36 may extend between the first end 31A and the second end 32A.

The cutout surface 35 and the plate-shaped filter 36 each have a shape which increases in width from the first end 31A toward the second end 32A, the width being along a direction orthogonal to a direction in which the filter 30A extends. Further, as shown in Fig. 3, each of the cutout surface 35 and the plate-shaped filter 36 is formed at two positions symmetrically with respect to the center line L1 of the filter 30A along the direction in which the filter 30A extends. The plate-shaped filter 36 can be attached, for example, by welding or fusing. Specifically, the plate-shaped filter 36 can be attached by fusion welding, pressure welding or brazing.

### <Filtration accuracy of filter 30A>

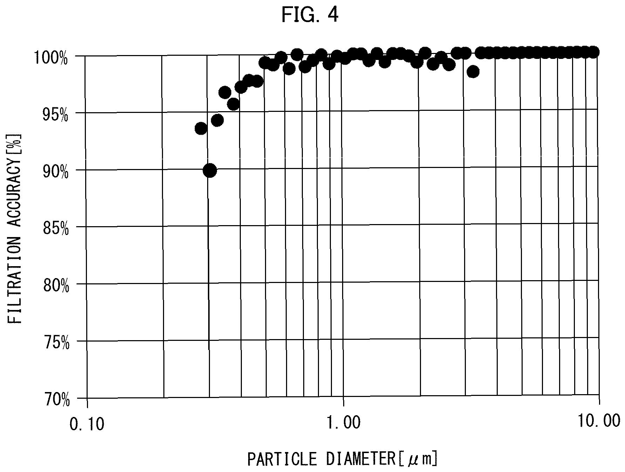

Fig. 4 shows a filtration accuracy of the filter 30A illustrated in Fig. 3. According to a result of observation of impurities under a scanning electron microscope by the inventor of the present invention, the size of the impurities which have mixed in the raw material gas G1 fed into the reactor 10 is not less than approximately 1 µm. Therefore, it is preferable that the filtration accuracy of the filter 30A is not less than 95% with respect to particles having a particle diameter of not less than 1 µm. In other words, it is preferable that the filter 30A remove 95% of the particles having a particle diameter of not less than 1 µm.

Further, from the viewpoint of removing finer impurities by the filter 30A, as shown in Fig. 4, it is preferable that the filtration accuracy of the filter 30A be not less than 90% with respect to particles having a particle diameter of not less than 0.3 µm. That is, it is preferable that the filter 30A remove not less than 90% of the particles having a particle diameter of not less than 0.3 µm. According to the above configuration, it is possible to highly efficiently remove impurities which have mixed in the raw material gas G1.

Note that the "filtration accuracy" in the present specification means a filtration accuracy which is measured by the following method. The following will discuss, as an example, a case in which the filtration accuracy of the filter 30A is measured. First, air cleaner test dust (hereinafter, referred to as AC dust) is fed to an upstream side of the filter 30A by using a dry dispersion type aerosol generator (RBG1000, manufactured by PALAS Corporation).

At this time, the diameter of a syringe for feeding a compressed powder of the AC dust is set to 7 mm, and a feed rate of the compressed powder of the AC dust is set to 5 mm/h. The feed rate corresponds to a feed rate of 190 mg/h of a case in which the compressed powder is assumed to have a bulk specific gravity of 1g/cc.

Further, at the same time as feeding the AC dust, dilution air is fed to the upstream side of the filter 30A at a flow rate of 40 L/min. Next, a particle size distribution on the upstream side of the filter 30A is measured for 20 seconds, and thereafter, a particle size distribution on a downstream side of the filter 30A is measured for 20 seconds. Then, the filtration accuracy at each particle diameter is calculated by dividing the average number of particles [the number of particles/cm³] on the downstream side of the filter 30A by the average number of particles [the number of particles/cm³] on the upstream side of the filter 30A.

The particle size distribution on the upstream side of the filter 30A and the particle size distribution on the downstream side of the filter 30A are measured three times repeatedly. Then, the average value of the filtration accuracies calculated in these three measurements is defined as the final filtration accuracy of the filter 30A. The filtration accuracy of the filter 30A was measured in this way, and as a result, the filtration accuracy shown in Fig. 4 was obtained. In Fig. 4, the horizontal axis represents the particle diameter [µm], and the vertical axis represents the filtration accuracy [%].

Fig. 4 shows measurement results that are obtained from measurements in which a filter used was the filter 30A and a filter made of a sintered body is used as the plate-shaped filter 36. Further, in the measurement results, the filter 30A is a filter made of SUS316L, and the dimensions of the filter 30A are as below.

As illustrated in the diagram indicated by "FA" in Fig. 3, the length M1 of an opening of the filter 30A along the direction in which the filter 30A extends is 300 mm, and the length M2 of a tip end portion T1 of the filter 30A along the direction in which the filter 30A extends is 50 mm. The plate-shaped filter 36 has a thickness of 1 mm. The filter 30A is produced by cutting a part of a pipe. This pipe has an outer diameter of 27.2 mm and an inner diameter of 23.9 mm.

### Embodiment 3

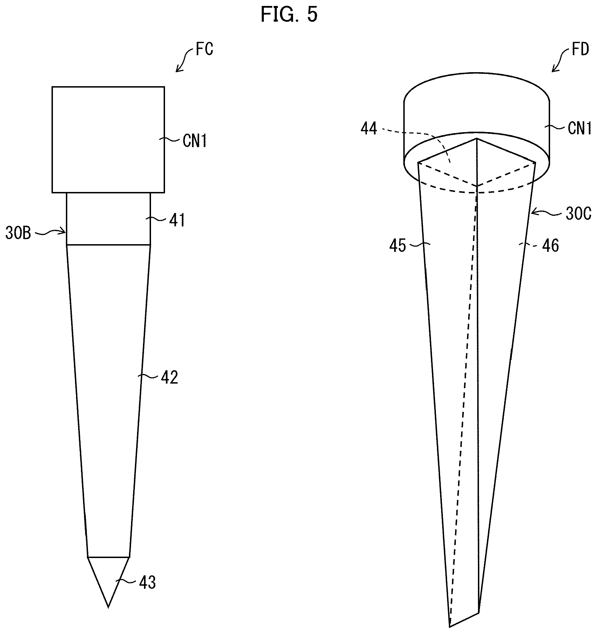

The following will discuss Embodiment 3 of the present invention. Note that, for convenience of explanation, a member having the same function as the member described in Embodiment 1 or 2 will be given the same reference sign, and a description thereof will not be repeated. Fig. 5 is a view illustrating an example of a configuration of a filter provided in an apparatus in accordance with Embodiment 3 of the present invention for producing polycrystalline silicon S1. In Fig. 5, a diagram indicated by "FC" is a front view of a filter 30B, and a view indicated by "FD" is a perspective view of a filter 30C.

The above production apparatus in accordance with Embodiment 3 differs from the production apparatus 1 in accordance with Embodiment 1 in that the filter 30 is replaced by the filter 30B or the filter 30C. As illustrated in the diagram indicated by "FC" in Fig. 5, the filter 30B is composed of a cylindrical portion 41, a central portion 42 and a conical portion 43. The cylindrical portion 41, the central portion 42, and the conical portion 43 are formed in this order from a downstream side of the feed channel.

The cylindrical portion 41 has a cylindrical shape, and is connected to a connecting member CN1. The central portion 42 has a truncated cone shape. The conical portion 43 has a cone shape. The central portion 42 and the conical portion 43 are formed such that the inclination angle of the central portion 42 is smaller than the inclination angle of the conical portion 43.

A portion of the filter 30B may be tapered due to the central portion 42 and the conical portion 43. The configuration of the filter 30B makes it difficult to cause obstruction due to the filter 30B to flow of a raw material gas G1. Note that a whole body of a filter provided in the production apparatus in accordance with Embodiment 3 may have a cone shape.

As illustrated in the diagram indicated by "FD" in Fig. 5, the filter 30C has the shape of a triangular prism. The filter 30C has three quadrangular surfaces of the triangular prism. Among the three surfaces, a quadrangular surface 44 having the smallest area is connected to the connecting member CN1. Note that the filter 30C may have the surface 44 which has a shape changed to a polygonal shape other than a quadrangular shape.

Among the three quadrangular surfaces of the triangular prism of the filter 30C, the other two surfaces 45 and 46 other than the surface 44 extend along the feed channel. The filter 30C may be tapered due to the triangular prism. Note that the production apparatus in accordance with Embodiment 3 may be provided with a filter which has the shape of a polygonal pyramid such as a triangular pyramid or a quadrangular pyramid. In this case, the polygonal pyramid has a base connected to the connecting member CN1, and an apex located on an upstream side of the feed channel.

### Embodiment 4

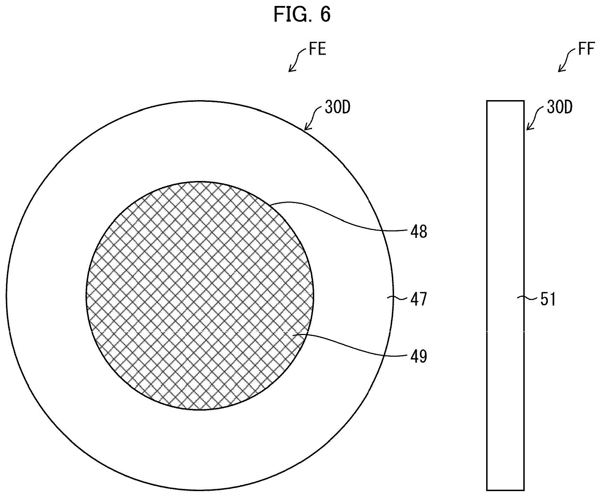

The following will discuss Embodiment 4 of the present invention. Note that, for convenience of explanation, a member having the same function as the member described in any one of Embodiments 1 to 3 will be given the same reference sign, and a description thereof will not be repeated. Fig. 6 is a view illustrating an example of a configuration of a filter which is provided in an apparatus in accordance with Embodiment 4 of the present invention for producing polycrystalline silicon S1. In Fig. 6, a diagram indicated by "FE" is a front view of a filter 30D, and a diagram indicated by "FF" is a side view of the filter 30D.

The above production apparatus in accordance with Embodiment 4 differs from the production apparatus 1 in accordance with Embodiment 1 in that the filter 30 is replaced by the filter 30D. As illustrated in the diagram indicated by "FE" in Fig. 6, the filter 30D has a disc shape. The filter 30D has an opening 48 which is formed in the center of a flat surface 47 on a front side of the filter 30D, and a plate-shaped filter 49 is fit in the opening 48 so as to close the opening 48.

Further, as illustrated in the diagram indicated by "FF" in Fig. 6, the filter 30D has a side surface 51. The side surface 51 is connected to a connecting member CN1. In this case, it is preferable that the filter 30D extend in a direction orthogonal to a direction in which the material gas G1 flows through the feed channel. Note that the shape of the filter 30D is not limited to the disk shape. The filter 30D may have, for example, a quadrangular shape or a triangular shape other than the circular shape, as the shape of a flat surface orthogonal to the direction in which the material gas G1 flows. Further, the filter 30D may extend in a direction which is inclined from the direction orthogonal to the direction in which the raw material gas G1 flows through the feed channel.

Aspects of the present invention can also be expressed as follows:
An apparatus in accordance with an aspect of the present invention for producing polycrystalline silicon includes: a reactor that contains a raw material gas for silicon deposition; a pipe that forms a feed channel for feeding the raw material gas into the reactor, the feed channel including an inflow port which is formed in the reactor and through which the raw material gas flows in; and a filter for removing an impurity which has mixed in the raw material gas, the filter being provided in the feed channel.

According to the above configuration, the impurity which has mixed in the raw material gas for silicon deposition can be removed by the filter. Therefore, the polycrystalline silicon can be produced by feeding, into the reactor, the raw material gas from which the impurity has been removed. Therefore, it is possible to reduce the impurity concentration of the polycrystalline silicon to be produced.

The filter can be provided at the inflow port in the feed channel. According to this configuration, since the filter is provided at the inflow port, the amount of the impurity which enters the reactor can be minimized.

The raw material gas can be a mixed gas of a chlorosilane and hydrogen. According to this configuration, it is possible to prevent rust or chloride from entering the reactor, even in a case where (i) a chlorosilane having chlorine in a molecule and also having corrosivity is contained in the raw material gas, (ii) rust and chlorides are generated on a surface of the pipe due to corrosion of a material of the pipe, and (iii) part of the rust and chlorides mixes in the raw material gas.

The pipe forming the feed channel can be made of stainless steel. According to this configuration, it is possible to prevent, for example, at least one of iron (Fe), nickel (Ni), chrome (Cr), manganese (Mn), copper (Cu), titanium (Ti), molybdenum (Mo) and niobium (Nb), which are heavy metals, from entering the reactor due to a constituent element(s) of stainless steel.

The filter can have a filtration accuracy of not less than 90% with respect to particles having a particle diameter of not less than 0.3 µm. According to this configuration, it is possible to highly efficiently remove the impurity which has mixed in the raw material gas.

At least a portion of the filter can be tapered from the inflow port toward an upstream side of the feed channel, or tapered from the upstream side of the feed channel toward the inflow port.

The following will discuss a case of using the filter which has at least a portion that is tapered from the inflow port toward the upstream side of the feed channel according to the above configuration. In this case, even when the raw material gas collides with the filter, it is possible to reduce obstruction caused by the filter to flow of the raw material gas. This makes it possible to reduce pressure loss which occurs in the raw material gas due to installation of the filter.

On the other hand, the following examines a case of using the filter which has at least a portion that is tapered from the upstream side of the feed channel toward the inflow port. Even in this case, since a space through which the raw material gas passes becomes wider from the upstream side of the feed channel toward the inflow port, it is possible to cause the raw material gas to smoothly pass through the feed channel. Therefore, the pressure loss of the raw material gas due to the installation of the filter can be reduced.

The filter can be shaped such that a first end of the filter is open while a second end of the filter on a side opposite to the first end is closed and that a filter surface extends between the first end and the second end; and an outer periphery of the first end can be fixed to an inner wall of the feed channel such that the first end and the second end are aligned along the inner wall of the feed channel.

According to the above configuration, the surface area of the filter can be increased. This makes it possible to reduce pressure loss which occurs in the raw material gas due to installation of the filter. Further, it is possible to stably feed the raw material gas without blockage of the filter, until deposition of the polycrystalline silicon completes. Therefore, it is possible to efficiently produce the polycrystalline silicon.

A method in accordance with an aspect of the present invention for producing polycrystalline silicon includes the steps of: removing an impurity which has mixed in a raw material gas for silicon deposition, by a filter provided in a feed channel for feeding the raw material gas into a reactor which contains the raw material gas; and depositing polycrystalline silicon by feeding, into the reactor, the raw material gas from which the impurity has been removed in the step of removing the impurity.

The step of removing the impurity can be carried out immediately before feeding the raw material gas into the reactor. According to the above configuration, since the step of removing the impurity is carried out immediately before feeding the raw material gas into the reactor, the amount of the impurity which enters the reactor can be minimized.

Polycrystalline silicon in accordance with an aspect of the present invention can be produced by a method described above for producing polycrystalline silicon.

The present invention is not limited to the embodiments described above, but may be altered in various ways by a skilled person within the scope of the claims. Specifically, any embodiment based on a proper combination of technical means disclosed in different embodiments is also encompassed in the technical scope of the present invention.

### Example

The following description will more specifically describe embodiments of the present invention with reference to an Example. However, the present invention is not limited by the Example. Polycrystalline silicon rods were produced by using an apparatus for producing polycrystalline silicon S1, the production apparatus having the structure of Embodiment 2 of the present invention. In other words, polycrystalline silicon rods were produced by using a production apparatus which is obtained by replacing, by the filter 10A, the filter 30 in the production apparatus 1 illustrated in Fig. 1. The reactor 10 could stand 10 polycrystalline silicon rods (five pairs of inverted U-shaped materials of polycrystalline silicon S1). Polycrystalline silicon rods were produced as described below, by using such an apparatus for producing the polycrystalline silicon S1.

Current was applied to each silicon core wire which was placed on the base part 11 of the reactor 10 so that the silicon core wire was heated to a temperature of approximately 1000°C. The silicon core wire had an inverted U shape and a height of 2000 mm. In addition to the heating, a sufficiently purified mixed gas of trichlorosilane and hydrogen was caused to flow into the feed pipe 20 and was fed into the reactor 10. This lead to deposition of polycrystalline silicon on the each silicon core wire (having an 8-mm square cross section). The deposition of the polycrystalline silicon was continued until the polycrystalline silicon rods were grown to have a diameter of 120 mm.

Note that in the apparatus for producing the polycrystalline silicon S1, the feed pipe 20 was made of stainless steel, and prior to carrying out the present Example, production of polycrystalline silicon rods under identical conditions had been repeated 100 times. The filter used was the filter 30A made of SUS316L and illustrated in Fig. 3. Further, the filtration accuracy of the filter 30A was a filtration accuracy at which not less than 90% of particles having a particle diameter of not less than 0.3 µm could be removed. The filter 30A was attached to the feed pipe 20 at a position illustrated in Fig. 2.

For each of the polycrystalline silicon rods which had been produced under the above conditions, the state of contamination caused by metal impurities was checked. Measurement for checking the state of contamination was carried out as described below. From an intermediate area of the polycrystalline silicon in the longitudinal direction of the polycrystalline silicon rod, a cylindrical body was cut out along a horizontal direction orthogonal to the longitudinal direction. The cylindrical body thus obtained had a diameter of 10 mm and a length of 120 mm. The cylindrical body is a body extending in the horizontal direction.

The following considers the cylindrical body of polycrystalline silicon which has been obtained by cutting out the polycrystalline silicon rod. Here, the term "radial direction" refers to the radial direction in a cross section of the polycrystalline silicon rod. The cylindrical body was vertically cut at positions which were ±2 mm away in the radial direction from a position 4 mm inward in the radial direction from one end of the cylindrical body (outer skin surface of the polycrystalline silicon rod), so that a cylindrical sample for measurement of an outer skin portion was obtained. The sample for measurement had a diameter of 10 mm and a height of 4 mm. Similarly, the cylindrical body was vertically cut at positions ±2 mm away in the radial direction from a position 30 mm inward from the one end (the outer skin surface) of the cylindrical body (the position 30 mm inward corresponds to a position at 1/2 of a radius of the cross section of the polycrystalline silicon rod), so that a sample for measurement of an intermediate portion was obtained. Further, the cylindrical body was vertically cut at the center position of the cross section of the polycrystalline silicon rod and at a position 4 mm outward in the radial direction from the center position, so that a sample for measurement of a core wire portion was obtained.

Each of these samples for measurement was analyzed for metal content. Specifically, the sample for measurement, which was a target of measurement, was dissolved in a fluonitric acid mixed solution, and a resultant solution in which the sample was dissolved was analyzed for respective amounts of metal elements of Cr, Fe, and Ni, by inductively coupled plasma-mass spectrometry (ICP-MS). For each of the above samples for measurement, an average value of analysis values of 10 polycrystalline silicon rods was obtained as a metal concentration in each of the above portions of the polycrystalline silicon rods. Table 1 below shows the metal concentration in each of the portions, as a result of the present Example.

**[Table 1]**

| | Cr [pptw] | Fe [pptw] | Ni [pptw] |
|---|---|---|---|
| Core wire portion | 9 | 29 | 2 |
| Intermediate portion | 4 | 19 | 2 |
| Outer skin portion | 1 | 12 | 3 |

### [Comparative Example]

In Comparative Example, except that no filter 30A was provided in the feed pipe 20, polycrystalline silicon rods were produced as in the above-described Example. For each of the polycrystalline silicon rods thus obtained, the state of contamination caused by metal impurities was checked as in the above-described Example. Table 2 below shows a metal concentration in each of portions as a result of the present Comparative Example.

**[Table 2]**

| | Cr [pptw] | Fe [pptw] | Ni [pptw] |
|---|---|---|---|
| Core wire portion | 13 | 59 | 7 |
| Intermediate portion | 7 | 54 | 8 |
| Outer skin portion | 2 | 17 | 7 |

As is apparent from a comparison between Table 1 and Table 2, the polycrystalline silicon rod of the present Example had significantly reduced respective metal concentrations of Cr, Fe, and Ni in each of the core wire portion, the intermediate portion, and the outer skin portion, as compared with the polycrystalline silicon rod of the present Comparative Example. It was possible to confirm, from this result, a significant effect of suppressing, by providing the feed pipe 20 with the filter 30A, contamination caused by metal impurities.

### Industrial Applicability

An embodiment of the present invention can be used in production of polycrystalline silicon.

### Reference Signs List

- 1: apparatus for producing polycrystalline silicon
- 10: reactor
- 20: feed pipe (pipe)
- 30, 30A, 30B, 30C, 30D: filter
- 31, 31A: first end
- 32, 32A: second end
- 33: filter surface
- 111, E1: inflow port
- G1: material gas
- S1: polycrystalline silicon

## Claims

1. An apparatus for producing polycrystalline silicon, comprising:
- a reactor that contains a raw material gas for silicon deposition;
- a pipe that forms a feed channel for feeding the raw material gas into the reactor, the feed channel including an inflow port which is formed in the reactor and through which the raw material gas flows in; and
- a filter for removing an impurity which has mixed in the raw material gas, the filter being provided in the feed channel.

2. The apparatus as set forth in claim 1, wherein the filter is provided at the inflow port in the feed channel.

3. The apparatus as set forth in claim 1 or 2, wherein the raw material gas is a mixed gas of a chlorosilane and hydrogen.

4. The apparatus as set forth in any one of claims 1 to 3, wherein the pipe forming the feed channel is made of stainless steel.

5. The apparatus as set forth in any one of claims 1 to 4, wherein the filter has a filtration accuracy of not less than 90% with respect to particles having a particle diameter of not less than 0.3 µm.

6. The apparatus as set forth in any one of claims 1 to 5, wherein at least a portion of the filter is tapered from the inflow port toward an upstream side of the feed channel, or tapered from the upstream side of the feed channel toward the inflow port.

7. The apparatus as set forth in any one of claims 1 to 6, wherein:
- the filter is shaped such that a first end of the filter is open while a second end of the filter on a side opposite to the first end is closed and that a filter surface extends between the first end and the second end; and
- an outer periphery of the first end is fixed to an inner wall of the feed channel such that the first end and the second end are aligned along the inner wall of the feed channel.

8. A method for producing polycrystalline silicon, comprising the steps of:
- removing an impurity which has mixed in a raw material gas for silicon deposition, by a filter provided in a feed channel for feeding the raw material gas into a reactor which contains the raw material gas; and
- depositing polycrystalline silicon by feeding, into the reactor, the raw material gas from which the impurity has been removed in the step of removing the impurity.

9. A method as set forth in claim 8, wherein the step of removing the impurity is carried out immediately before feeding the raw material gas into the reactor.

10. Polycrystalline silicon produced by a method recited in claim 8 or 9 for producing polycrystalline silicon.
